# EUROPÄISCHE PATENTSCHRIFT

(11) **EP 1 000 529 B1**
(45) Veröffentlichungstag und Bekanntmachung des Hinweises auf die Patenterteilung: **16.01.2002**
(21) Anmeldenummer: 98925489.1
(22) Anmeldetag: 28.04.1998
(51) Int. Cl.: H05K 3/12, G06K 7/10

(54) **VERFAHREN UND VORRICHTUNG ZUM ERZEUGEN VON TESTPATTERN BEIM LOTPASTENAUFTRAG MITTELS SIEBDRUCKVERFAHRENS AUF LEITERPLATTEN**
PROCESS AND DEVICE FOR GENERATING TEST PATTERNS WHEN APPLYING SOLDER PASTE BY A SCREEN PRINTING PROCESS ON PRINTED CIRCUIT BOARDS
PROCEDE ET DISPOSITIF POUR GENERER DES MOTIFS DE CONTROLE LORS DE L'APPLICATION DE P TE A SOUDER AU MOYEN D'UN PROCEDE DE SERIGRAPHIE SUR DES CARTES DE CIRCUITS IMPRIMES

(30) Priorität: 02.07.1997 DE 19728144
(43) Veröffentlichungstag der Anmeldung: 17.05.2000
(73) Patentinhaber: Ekra Eduard Kraft GmbH, 74355 Bönnigheim (DE)
(72) Erfinder: SCHANZ, Karl, D-74080 Heilbronn (DE)
(74) Vertreter: Grosse, Rainer, Dipl.-Ing.
(86) Internationale Anmeldenummer: EP9802496
(87) Internationale Veröffentlichungsnummer: WO9902021

(56) Entgegenhaltungen:
- EP-A- 0 379 013
- EP-A- 0 394 568
- EP-A- 0 786 702
- DE-A- 3 928 527
- DE-A- 4 239 995

## Beschreibung

Die Erfindung betrifft ein Verfahren zum Erzeugen von Testpattern beim Lotpastenauftrag mittels Siebdruckverfahrens auf Leiterplatten, wobei in einem Teach-In-Verfahrensschritt als Referenzmuster eine Struktur optisch erfaßt und aus dieser Erfassung Referenzdaten für die Testpattern generiert werden.

Im Rahmen eines Inspektionssystems ist es bekannt, die Zulänglichkeit des Auftrags von Lotpaste auf Leiterplatten zu überwachen. Die Lotpaste wird im Siebdruckverfahren auf die Leiterplatten aufgebracht. Sie ermöglicht es, im nachfolgenden Bestükkungsprozeß elektronische Bauteile mit auf den Leiterplatten ausgebildeten Leiterbahnanschlüssen zu verlöten. Dies erfolgt insbesondere im SMD-Prozeß. Um den Lotpastenauftrag im Zuge des Inspektionssystems kontrollieren zu können, ist es erforderlich, sogenannte Testpattern bereitzustellen. Diese definieren, wo und wie die Kontrolle des Lotpastenauftrags durchgeführt werden soll. Die Testpattern definieren die Koordinaten, Größe und Form der aufzubringenden Lotpastenbereiche. Zur Gewinnung von Testpattern sind grundsätzlich zwei Verfahren bekannt. Das erste Verfahren gewinnt die Testpattern aus CAD-Daten. Dieses sind in elektronischer Form zur Verfügung stehende Schablonendaten (Gerberfiles) der Druckschablone. Diese Daten geben Informationen darüber, wo und wie die Druckschablone Durchbrüche aufweist, durch die im Siebdruckverfahren Lotpaste auf die Leiterplatte aufgetragen wird. Wegen Problemen bei der Verfügbarkeit, der Aktualität und der Konvertierbarkeit der CAD-Daten hat sich das nachfolgend erwähnte zweite Verfahren in der Vergangenheit als praktikablere Lösung herausgestellt. Dieses zweite Verfahren ist ein sogenanntes Teach-In-Verfahren, bei dem die Leiterplatte als Referenzmuster zur Testpatternerzeugung dient. Mithin wird die Leiterbahn- und Anschlußstruktur einer Leiterplatte mittels einer Kamera erfaßt und auf diese Art und Weise die Testpattern im Teach-In-Verfahren bestimmt. Nachteilig ist, daß die Strukturen von Leiterbahnen -bedingt durch ihren Herstellungsprozeß- relativ große Maßtoleranzen aufweisen, so daß die Testpatternerzeugung maßlichen Abweichungen unterliegt. Insbesondere bei sehr eng aneinandergrenzenden Kontaktstrukturen, beispielsweise für hochintegrierte Bauelemente, kann die maßliche Unzulänglichkeit zu einem Problem führen.

Die deutsche Patentschrift 39 28 527 C2 betrifft eine Flachbett-Siebdruckmaschine zum Bedrucken einer elektrischen Leiterplatte, wobei zunächst ein Aufdruck auf einer Leiterplatte erfaßt wird. Danach wird die Lage der Druckschablone optisch bestimmt und Abweichungen zwischen Leiterplatte und Druckschablone korrigiert. Schließlich wird dann die Leiterplatte ein weiteres Mal bedruckt. Demgemäß weist die Leiterplatte erste Referenzmarken auf, deren Ist-Lage erfaßt und mit gespeicherten Referenzwerten verglichen werden kann. Dann wird die Ist-Lage von auf dem Drucksieb festgelegten zweiten Referenzmarken erfaßt und ein Vergleich mit zweiten gespeicherten Referenzwerten vorgenommen. Aus der Abweichung der Ist-Lagen der ersten und zweiten Referenzmarken von ihren Referenzwerten wird eine Soll-Lage der zweiten Referenzmarken errechnet, bei der das zweite Druckbild auf das erste Druckbild abgeglichen ist. Hieraus wird dann ein Steuersignal abgeleitet, das einen motorisch angetriebenen Verschiebeschlitten ansteuert, um das Drucksieb bis zum Abgleich zu verschieben.

Der Erfindung liegt die Aufgabe zugrunde, ein Verfahren der eingangs genannten Art anzugeben, daß hochpräzise Ergebnisse liefert und praktikabel durchführbar ist.

Diese Aufgabe wird erfindungsgemäß dadurch gelöst, daß als Struktur die Druckschablone für das Siebdruckverfahren optisch erfaßt wird und daß die Schablonenöffnungen der Druckschablone hinsichtlich ihrer Lage (Koordinaten) und/oder ihrer Geometrie (Form, Größe) erfaßt werden. Mithin wird erfindungsgemäß im Teach-In-Verfahren die Druckschablone als Referenzmuster zur Testpatternerzeugung herangezogen. Die so ermittelten Prüfdaten entsprechen exakt den beim Druckprozeß vorliegenden Gegebenheiten, so daß die Druckqualität und Maßhaltigkeit unabhängig von anderen Einflüssen optimal beurteilt werden kann. Die gemessene Lotpastenauftrags-Druckgüte läßt direkte Rückschlüsse auf den Druckprozeß zu, ohne daß Störfaktoren -beispielsweise wie die zuvor genannten Toleranzeinflüsseauftreten. Um die Testpattern zu erzeugen, werden vorzugsweise bestimmte Bereiche -die hinsichtlich etwaiger Fehler besonders anfällig sind- festgelegt und in diesen Bereichen die Testpattern mittels optischer Erfassung der Struktur (Schablonenöffnungen) der Druckschablone erzeugt. Das optisch erfaßte Bild wird elektronisch in Daten umgesetzt, die die Testpattern darstellen. Diese Testpattern bilden das Referenzmuster, das -nach dem Siebdruckprozeß- mit den ebenfalls optisch ermittelten Daten des tatsächlichen Lotpastenauftrags verglichen wird. Auf diese Art und Weise lassen sich Fehler erkennen, die beispielsweise darin bestehen, daß zwei Anschlüsse der Leiterplatte mittels einer nicht gewünschten Lotpastenbrücke elektrisch verbunden werden. Ferner ist erkennbar, ob Lotpaste in bestimmten Bereichen fehlt. Dies wiederum kann zwei Gründe haben, nämlich einerseits ein Festkleben der Lotpaste an der Druckschablone, da die Lotpaste nicht auf die Leiterplatte übertragen wurde oder es steht andererseits zu wenig Lotpaste zur Verfügung, das heißt, vom Rakel konnte mangels Menge nicht in alle Bereiche Lotpaste verstrichen werden. Nach dem bisher bekannten Verfahren wird der Lotpastenauftrag optisch erfaßt und mit den auf die bisherige Art gewonnenen Testpattern verglichen. Das Vergleichen erfolgt ebenfalls beim Gegenstand der Erfindung, wobei hinzutritt, daß die Druckschablone -wegen der Testpatternerzeugung- ebenfalls optisch abgetastet wird. Mithin sind sowohl der Druckschablone als auch der Leiterplatte eine optoelektronische Erfassungseinrichtung zugeordnet, was nachstehende, bisher nicht zu realisierende Vorteile bietet. Es ist möglich, die von der Druckschablone und von der Leiterplatte gewonnenen Bilder vorzugsweise selbsttätig elektronisch zu vergleichen, wobei Fehler beziehungsweise sich aufbauende Fehler erkannt und möglicherweise bereits im Vorfeld abgestellt werden können. So bauen sich Brücken zumeist erst langsam auf, das heißt, an der Druckschablone, insbesondere an den Rändern der Druckschablonenöffnungen, wird erkennbar, daß sich dort Partikel der Lotpaste im Laufe der Zeit immer mehr ansammeln und aufbauen, bis es zu der Brückenbildung kommt. Dieser fortschreitende Aufbau wird aufgrund der optoelektronischen Abtastung der Druckschablone im Zuge seines Entstehens erkannt und kann daher abgestellt werden. Dies erfolgt vorzugsweise automatisch, indem der Druckprozeß kurzzeitig unterbrochen und automatisch eine Druckschablonenreinigung durchgeführt wird. Entsprechendes gilt für Lotpaste, die in den Öffnungen der Druckschablone festklebt und daher nicht auf die Leiterplatte übertragen wird, da auch dort in einem sich aufbauenden Prozeß zunächst nur geringfügige Mengen an den Schablonenöffnungen haften bleibt, die sich langsam aufbauen, bis schließlich die Paste die gesamte Öffnung oder einen Großteil der Öffnung verklebt. Die optische Abtastung der Druckschablone wird somit zweifach genutzt, nämlich zum einen für die Testpatternerzeugung und zum anderen zur Fehlererkennung. Neben der einfachen Erzeugung des Testpattern mittels des erfindungsgemäßen Vorgehens ist somit eine optimale Kontrolle während des Siebdruckprozesses hinsichtlich möglicher Fehler durchführbar. Erfindungsgemäß ist vorgesehen, daß die Druckschablonenöffnungen der Druckschablone hinsichtlich ihrer Lage (Koordinaten) und/oder ihrer Geometrie (Form, Größe) optisch erfaßt werden. Die Testpattern weisen demgemäß entsprechende Informationen, also über die Lage (Koordinaten) und die Geometrie (Form, Größe) auf.

Ferner ist es vorteilhaft, wenn die der Leiterplatte zugewandte Seite der Druckschablone optisch erfaßt wird. Die Erfassung der "Unterseite" hat den Vorteil, daß dort -neben der Erfassung der Testpatterndaten- am besten erkannt werden kann, ob Fehler im Laufe des fortschreitenden Druckprozesses auftretenden können, beispielsweise die erwähnte Brükkenbildung oder das Verkleben von Lotpaste.

Nach einer Weiterbildung der Erfindung ist vorgesehen, daß nach dem Siebdruckprozeß eine optische Erfassung des auf die Leiterplatte erfolgten Lotpastenauftrags durchgeführt wird und daß aus dieser Erfassung Istdaten generiert werden. Mit Hilfe dieser Istdaten ist eine Beurteilung des Lotpastenauftrags im Zuge des Inspektionssystems auf besonders einfache Weise möglich, da lediglich ein Vergleich der Daten des Referenzmusters mit den Istdaten durchgeführt werden muß. Es erfolgt somit eine Auswertung der Istdaten unter Berücksichtigung der Referenzdaten.

Die Erfindung betrifft ferner eine Vorrichtung zum Erzeugen von Testpattern beim Lotpastenauftrag mittels Siebdruckverfahrens auf Leiterplatten, mit einer ersten optoelektronischen Einrichtung zum in einem Teach-In-Verfahrensschritt erfolgenden Erfassen einer Struktur als Referenzmuster, und mit einer Datenverarbeitungselektronik zur Erzeugung von Referenzdaten aus der Referenzmustererfassung, wobei die erste optoelektronische Erfassung derart angeordnet ist, daß sie als Struktur die Schablonenöffnungen der Druckschablone hinsichtlich ihrer Lage (Koordinaten) und/oder ihrer Geometrie (Form, Größe) erfaßt. Diese optoelektronische Einrichtung gewinnt somit auf optischem Wege durch Erfassung der Struktur (Schablonenöffnungen) der Druckschablone Testpatterndaten, die bei der Auswertung des Lotpastenauftrags als Solldaten zur Verfügung stehen. Diese werden mit aus dem Lotpastenauftrag ermittelten Istdaten verglichen. Es können bei Abweichungen Korrekturen vorgenommen werden.

Es ist vorteilhaft, wenn eine Verlagerungsvorrichtung vorhanden ist, mit der die erste optoelektronische Einrichtung zwischen die Druckschablone und die Leiterplatte einfahrbar ist. Hierdurch läßt sich der jeweils gewünschte Bereich der Druckschablone optisch erfassen.

Vorteilhafterweise ist eine zweite optoelektronische Einrichtung zum Erfassen des Lotpastenauftrags auf der Leiterplatte vorgesehen, wobei insbesondere die erste und die zweite optoelektronische Einrichtung mittels derselben Verlagerungseinrichtung verfahrbar sind. Dies hat den Vorteil, daß für beide optoelektronische Einrichtungen nur eine Verlagerungseinrichtung erforderlich ist, so daß konstruktiver Aufwand und Kosten eingespart werden können. Die Verlagerung bei der optoelektronischen Einrichtung mittels ein und derselben Verlagerungseinrichtung hat jedoch auch noch den Vorteil, daß beide Einrichtungen stets in dieselbe Position im Hinblick auf die Druckschablone und im Hinblick auf die Leiterplatte verbracht werden, das heißt, die beiden optoelektronische Einrichtungen ermitteln stets sich entsprechende Bereiche der beiden Teile, so daß ein Soll-Ist-Vergleich auf besonders einfache Weise ermöglicht wird.

Ferner kann vorgesehen sein, daß die erste und die zweite optoelektronische Einrichtung von nur einer, hinsichtlich der Erfassungsrichtung umschaltbaren oder zwei Erfassungsstrahlengänge aufweisenden optoelektronischen Vorrichtung gebildet wird. Mithin sind die beiden optoelektronischen Einrichtungen in einer einzigen optoelektronischen Vorrichtung zusammengefaßt, die sich auf dem Verlagerungsschlitten der Verlagerungseinrichtung befindet. Der Aufwand verringert sich, wenn die Erfassungsrichtung umschaltbar ist, das heißt mit ein und derselben Optoelektronik wird die Druckschablone und -nach Umschaltung- die Leiterplatte erfaßt. Um einen Soll-Ist-Vergleich vornehmen zu können, ist es dann erforderlich, daß die zuerst erfaßte Bildstruktur gespeichert und dann mit der danach erfaßten Bildstruktur verglichen wird. Etwas bautechnisch aufwendiger, jedoch verfahrenstechnisch vorteilhafter ist die Ausgestaltung mittels zweier optoelektronischer Erfassungseinrichtungen (Kameras), wovon die eine mittels eines ersten Erfassungsstrahlenganges die Druckschablone und die andere mittels eines zweiten Erfassungsstrahlenganges die Leiterplatte und damit den dort erfolgten Lotpastenauftrag inspiziert.

Ferner kann vorgesehen sein, daß die optoelektronische Vorrichtung einen beidseitig verspiegelten, ersten Spiegel aufweist, dessen eine Seite im zur Druckschablone führenden Strahlengang und dessen andere Seite im zur Leiterplatte führenden Strahlengang liegt. Insbesondere ist dieser beidseitig verspiegelte erste Spiegel als Prisma ausgeführt, was den Vorteil hat, daß die Reflektionsebene für beide Strahlengänge quasi dieselbe ist.

Eine Weiterbildung der Erfindung sieht vor, daß jeder Seite des ersten Spiegels ein halbdurchlässiger, zweiter beziehungsweise dritter Spiegel zugeordnet ist. Dem zweiten und dem dritten Spiegel ist insbesondere jeweils eine erste beziehungsweise zweite Optik zugeordnet. Dem zweiten und dem dritten Spiegel ist bevorzugt jeweils ein erster beziehungsweise zweiter Bilderfassungssensor zugeordnet. Die Anordnung ist dabei vorzugsweise derart getroffen, daß die erste Optik zwischen dem zweiten Spiegel und dem ersten Bilderfassungssensor und die zweite Optik zwischen dem dritten Spiegel und dem zweiten Bilderfassungssensor liegt. Aufgrund des vorstehend erläuterten Aufbaus ist es möglich, daß über die eine Seite des ersten Spiegels und den halbdurchlässigen zweiten Spiegel sowie die erste Optik und mit Hilfe des ersten Bilderfassungssensors die Leiterplatte und mit Hilfe der anderen Seite des ersten Spiegels, dem dritten Spiegel sowie der zweiten Optik und dem zweiten Bilderfassungssensor die Druckschablone erfaßt werden kann.

Mit dem zweiten Spiegel wirkt eine erste Beleuchtungsquelle und mit dem dritten Spiegel eine zweite Beleuchtungsquelle zusammen, wodurch es möglich ist, mit Hilfe der ersten Beleuchtungsquelle über den zweiten Spiegel und den ersten Spiegel die Leiterplatte und mittels der zweiten Beleuchtungsquelle über den dritten Spiegel und den ersten Spiegel die Druckschablone zu beleuchten. Besonders gute Ergebnisse sind dadurch erzielbar, daß die Leiterplatte durch Licht einer ringförmigen oder etwa ringförmigen oder teilringförmigen dritten Beleuchtungsquelle beaufschlagt wird. Die dritte Beleuchtungsquelle befindet sich vorzugsweise an der mittels der Verlagerungseinrichtung verfahrbaren optoelektronischen Vorrichtung. Insbesondere ist vorgesehen, daß die dritte Beleuchtungsquelle aufgrund ihrer Ringstruktur den Strahlengang zwischen dem ersten Spiegel und der Leiterplatte umgibt, das heißt, es erfolgt eine optimale Ausleuchtung der Leiterplatte, so daß der Lotpastenauftrag darauf sehr gut optisch erfaßt werden kann.

Schließlich ist vorgesehen, daß die dritte Beleuchtungsquelle von mehreren Licht emittierenden Dioden (LED's) gebildet ist.

Die Zeichnungen veranschaulichen die Erfindung anhand eines Ausführungsbeispiels und zwar zeigt:
- Figur 1: eine Draufsicht auf die optoelektronische Vorrichtung,
- Figur 2: eine Stirnansicht auf die optoelektronische Vorrichtung in Richtung des Pfeiles II in Figur 1 und
- Figur 3: eine Unteransicht auf die optoelektronische Vorrichtung in Richtung des Pfeiles III in Figur 2.

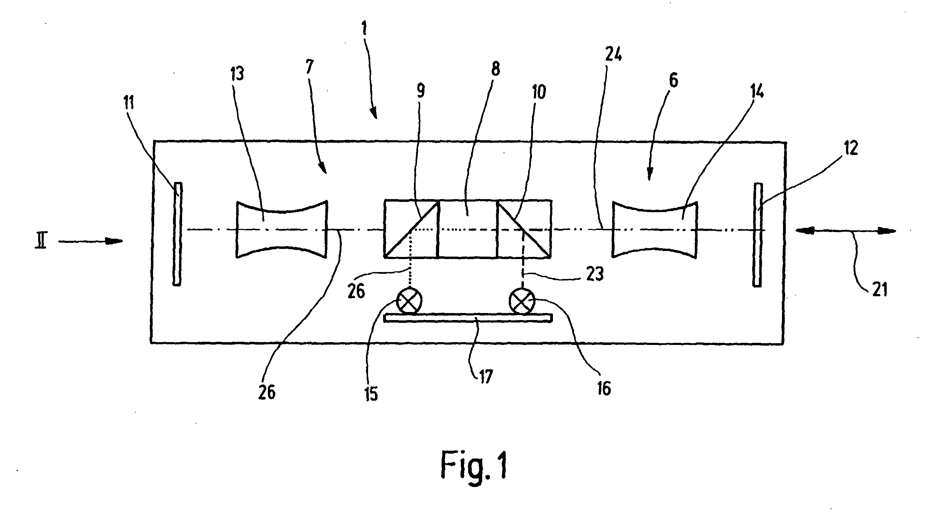

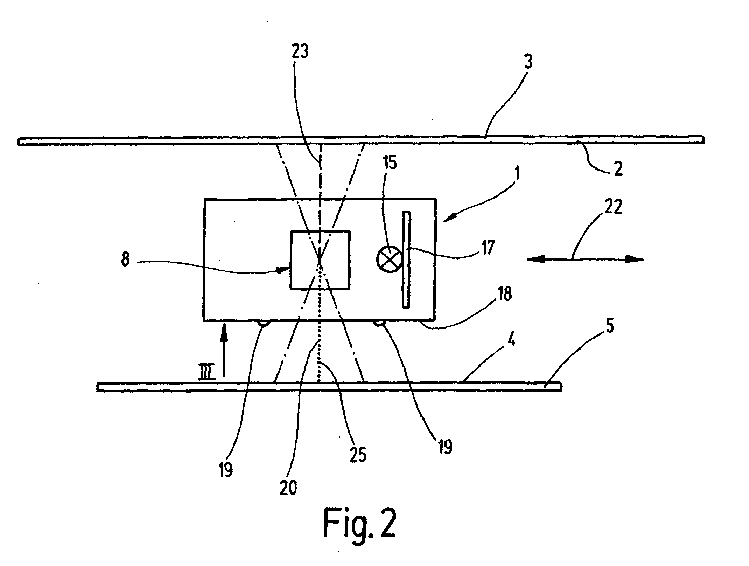

Die Figuren 1 bis 3 zeigen -in schematischer Darstellung- eine optoelektronische Vorrichtung 1, mit deren Hilfe die Erzeugung von Testpattern beim Lotpastenauftrag mittels Siebdruckverfahrens auf Leiterplatten erzeugt werden können. Ferner eignet sich diese optoelektronische Vorrichtung 1 zur Inspektion der Unterseite 2 einer im Siebdruckprozeß eingesetzten Druckschablone 3 sowie der Seite 4 der Leiterplatte 5, auf die im Siebdruckprozeß die Lotpaste aufgetragen wird (Figur 2).

Gemäß Figur 1 weist die optoelektronische Vorrichtung 1 eine erste optoelektronische Einrichtung 6 und eine zweite optoelektronische Einrichtung 7 auf. Den beiden optoelektronischen Einrichtungen 6 und 7 ist ein beidseitig verspiegelter, erster Spiegel 8 gemeinsam, dem ein halbdurchlässiger, zweiter Spiegel 9 der optoelektronischen Einrichtung 7 und ein halbdurchlässiger, dritter Spiegel 10 der optoelektronischen Einrichtung 6 zugeordnet ist. Ferner weist die optoelektronische Einrichtung 7 einen ersten Bilderfassungssensor 11 und die optoelektronische Einrichtung 6 einen zweiten Bilderfassungssensor 12 auf. Zwischen dem zweiten Spiegel 9 und dem ersten Bilderfassungssensor 11 befindet sich eine erste Optik 13. Zwischen dem dritten Spiegel 10 und dem zweiten Bilderfassungssensor 12 ist eine zweite Optik 14 angeordnet. Mithin ist die erste Optik 13 Bestandteil der zweiten optoelektronischen Einrichtung 7 und die zweite Optik 14 Bestandteil der ersten optoelektronischen Einrichtung 6. Die optoelektronische Einrichtung 7 weist ferner eine erste Beleuchtungsquelle 15 auf; der optoelektronischen Einrichtung 6 ist eine zweite Beleuchtungsquelle 16 zugeordnet. Die beiden Beleuchtungsquellen 15 und 16 sind vorzugsweise als LED's ausgebildet und befinden sich auf einer Leiterplatine 17.

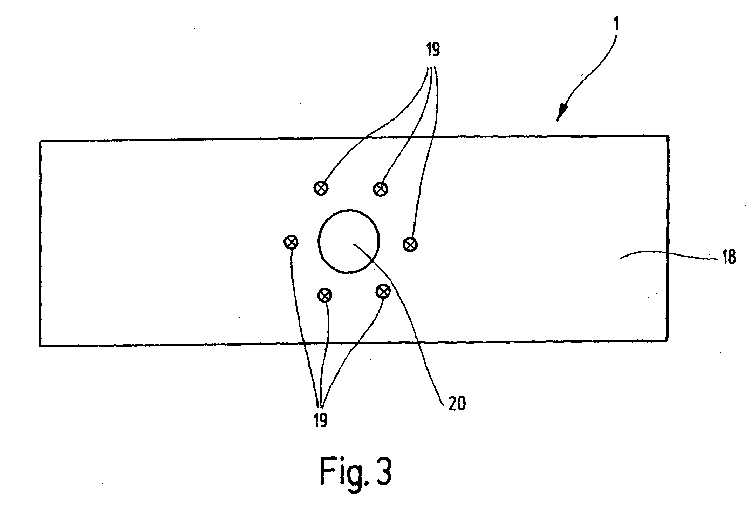

Gemäß der Figur 2 ist an der Unterseite 18 der optoelektronischen Vorrichtung 1 eine dritte Beleuchtungsquelle 19 angeordnet, die aus mehreren, ringförmig angeordneten lichtemittierenden Dioden (LED's) besteht. Die Anordnung ist derart getroffen, daß die dritte Beleuchtungsquelle 19 den Strahlengang 20 zwischen dem ersten Spiegel 8 und der Leiterplatte 5 umgibt. Dies geht insbesondere auch aus der Figur 3 hervor. Mittels einer schlittenartig arbeitenden, entlang zweier senkrecht äufeinanderstehender Koordinaten verfahrbaren Verlagerungseinrichtung (nicht dargestellt) ist die optoelektronische Vorrichtung 1 entlang des Doppelpfeils 21 in Figur 1 und entlang des Doppelpfeils 22 in Figur 2 verfahrbar, das heißt, sie kann in jede beliebige Position zur Druckschablone 3 und in die entsprechende Position zur Leiterplatte 5 verfahren werden. Dies erfolgt, sobald mittels der Druckschablone 3 Lotpaste auf die Seite 4 der Leiterplatte 5 im Siebdruckverfahren aufgebracht worden ist. Nach diesem Siebdruckprozeß werden Druckschablone 3 und Leiterplatte 2 auseinandergefahren, so daß im Zwischenraum die optoelektronische Vorrichtung 1 einfahren kann. Auf diese Art und Weise ist eine Inspektion im Hinblick auf die Zulänglichkeit des Lotpastenauftrags möglich. Dabei wird mittels der ersten optoelektronischen Einrichtung 6 die Unterseite 2 der Druckschablone 3 und mittels der zweiten optoelektronischen Einrichtung 7 die Seite 4 der Leiterplatte 5 inspiziert. Mittels einer nicht dargestellten Verarbeitungselektronik ist auf diese Art und Weise eine Prüfung des Lotpastenauftrags für etwaige Fehler möglich. Im einzelnen ergibt sich folgendes: Mittels der Beleuchtungsquelle 16 wird Licht auf den halbdurchlässigen Spiegel 10 geworfen (gestrichelte Linie 23), wobei dieses Licht um 90° umgelenkt dem ersten Spiegel 8 zugeführt wird und von der einen Seite dieses Spiegels 8 nach oben geleitet wird, so daß es auf die Unterseite 2 der Druckschablone 3 trifft. Von der Druckschablone 3 reflektiertes Licht gelangt zum Spiegel 8 zurück und wird von dessen gleicher Seite dem Spiegel 10 zugeführt, wobei der Spiegel 10 geradlinig passiert wird und das reflektierte Licht gemäß der strich-doppelpunktierten Linie 24 über die Optik 14 zum Bilderfassungssensor 12 gelangt. Dieser kann in Zusammenarbeit mit der nicht dargestellten Datenverarbeitungselektronik somit in Pixelstruktur ein entsprechendes Bild der Struktur, insbesondere der Koordinaten, Form und Größe der Schablonenöffnungen, der Druckschablone 3 erzeugen. Die so ermittelten Daten können für den vorstehend erwähnten Vergleich mit dem Lotpastenauftrag herangezogen werden. Insbesondere ist es möglich, daß die erfaßten Daten als Referenzmuster ausgewertet werden, das heißt, dieses Referenzmuster repräsentiert Testpattern, also eine Information darüber, welche Lage und welche Geometrie die Schablonenöffnungen der Druckschablone aufweisen. Die Erfassung erfolgt im sogenannten Teach-in-Verfahren.

Mittels der zweiten optoelektronischen Einrichtung 7 läßt sich der Lotpastenauftrag auf der Seite 4 der Leiterplatte 5 inspizieren. Hierzu wird Licht von der Beleuchtungsquelle 15 dem Spiegel 9 zugeleitet (gepunktete Linie 25), dort umgelenkt und der anderen Seite des ersten Spiegels 8 zugeführt, die das Licht nach unten auf die Leiterplatte 5 wirft. Das von der Leiterplatte 5, insbesondere von dem Lotpastenauftrag, reflektierte Licht gelangt zum Spiegel 8 zurück und wird von dort aus dem teildurchlässigen Spiegel 9 zugeführt, der geradlinig durchsetzt wird, so daß das Licht entlang der strichpunktierten Linie 26 über die Optik 13 zum Bilderfassungssensor 11 gelangt. Der Bilderfassungssensor 11 stellt -in Pixelform- Informationen über den Erfolg des Lotpastenauftrags auf die Leiterplatte 5 zur Verfügung. Mittels der Datenvearbeitungselektronik ist es nunmehr möglich, die Informationen der beiden Bilderfassungssensoren 11 und 12 auszuwerten, das heißt, das Referenzmuster der Druckschablone 3 wird verglichen mit dem Ist-Muster, also dem Lotpastenauftrag auf der Leiterplatte 5, wodurch etwaige Fehler erkennbar werden. Zusätzlich ist es möglich, mittels der ersten optoelektronischen Einrichtung 6 die Druckschablone 3 auf etwaige Verschmutzungen mit sich dort ansammelnder Lotpaste zu inspizieren, so daß frühzeitig aus derartigen Lotpastenanhaftungen resultierende Fehler erkannt werden können.

Wird ein Fehler festgestellt, so kann der Automatik-Betrieb gestoppt und der Fehler optisch auf einem Bildschirm angezeigt werden. Der Bediener hat die Möglichkeit, Fehler zu ignorieren oder Maßnahmen zu ergreifen. Es ist auch möglich, die dann fehlerhafte Leiterplatte zu entnehmen. Auf jeden Fall wird der Fehler mit dem Namen des Bauteils, das mittels des Lotpastenauftrags auf die Leiterplatte aufgebracht werden soll, zusammen mit der erfolgten Bedienerreaktion aufgezeichnet.

## Patentansprüche

1. Verfahren zum Erzeugen von Testpattern beim Lotpastenauftrag mittels Siebdruckverfahrens auf Leiterplatten, wobei in einem Teach-In-Verfahrensschritt als Referenzmuster eine Struktur optisch erfaßt und aus dieser Erfassung Referenzdaten für die Testpattern generiert werden, **dadurch gekennzeichnet, daß** als Struktur die Druckschablone für das Siebdruckverfahren optisch erfaßt wird und daß die Schablonenöffnungen der Druckschablone hinsichtlich ihrer Lage (Koordinaten) und/oder ihrer Geometrie (Form, Größe) erfaßt werden.

2. Verfahren nach Anspruch 1, **dadurch gekennzeichnet, daß** die der Leiterplatte zugewandte Seite der Druckschablone optisch erfaßt wird.

3. Verfahren nach einem der vorhergehenden Ansprüche, **dadurch gekennzeichnet, daß** nach dem Siebdruckprozeß eine optische Erfassung des auf die Leiterplatte erfolgten Lotpastenauftrags durchgeführt wird und daß aus dieser Erfassung Istdaten generiert werden.

4. Verfahren nach einem der vorhergehenden Ansprüche, **dadurch gekennzeichnet, daß** die Istdaten unter Berücksichtigung der Referenzdaten ausgewertet werden.

5. Vorrichtung zum Erzeugen von Testpattern beim Lotpastenauftrag mittels Siebdruckverfahrens auf Leiterplatten, mit einer ersten optoelektronischen Einrichtung zum in einem Teach-In-Verfahrensschritt erfolgenden Erfassen einer Struktur als Referenzmuster, und mit einer Datenverarbeitungselektronik zur Erzeugung von Referenzdaten aus der Referenzmustererfassung, **dadurch gekennzeichnet, daß** die erste optoelektronische Einrichtung (6) derart angeordnet ist, daß sie als Struktur die Schablonenöffnungen der Druckschablone hinsichtlich ihrer Lage (Koordinaten) und/oder ihrer Geometrie (Form, Größe) erfaßt.

6. Vorrichtung nach Anspruch 5, **gekennzeichnet durch** eine Verlagerungseinrichtung, mit der die erste optoelektronische Einrichtung (6) zwischen die Druckschablone (3) und die Leiterplatte (5) einfahrbar und dort verfahrbar ist.

7. Vorrichtung nach einem der vorhergehenden Ansprüchen, **gekennzeichnet durch** eine zweite optoelektronische Einrichtung (7) zum Erfassen des Lotpastenauftrags auf der Leiterplatte (5).

8. Vorrichtung nach einem der vorhergehenden Ansprüche, **dadurch gekennzeichnet, daß** die erste und die zweite optoelektronische Einrichtung (6,7) mittels ein und derselben Verlagerungseinrichtung verfahrbar sind.

9. Vorrichtung nach einem der vorhergehenden Ansprüche, **dadurch gekennzeichnet, daß** die erste und die zweite optoelektronische Einrichtung (6,7) von nur einer, hinsichtlich der Erfassungsrichtung umschaltbaren oder zwei Erfassungsstrahlengänge aufweisenden optoelektronischen Vorrichtung (1) gebildet wird.

10. Vorrichtung nach einem der vorhergehenden Ansprüche, **dadurch gekennzeichnet, daß** die optoelektronische Vorrichtung (1) einen beidseitig verspiegelten, ersten Spiegel (8) aufweist, dessen eine Seite im zur Druckschablone (3) führenden Strahlengang und dessen andere Seite im zur Leiterplatte (5) führenden Strahlengang liegt.

11. Vorrichtung nach einem der vorhergehenden Ansprüche, **dadurch gekennzeichnet, daß** jeder Seite des ersten Spiegels (8) ein halbdurchlässiger zweiter beziehungsweise dritter Spiegel (9,10) zugeordnet ist.

12. Vorrichtung nach einem der vorhergehenden Ansprüche, **dadurch gekennzeichnet, daß** dem zweiten und dem dritten Spiegel (9,10) jeweils eine erste beziehungsweise zweite Optik (13, 14) zugeordnet ist.

13. Vorrichtung nach einem der vorhergehenden Ansprüche, **dadurch gekennzeichnet, daß** dem zweiten und dem dritten Spiegel (9,10) jeweils ein erster beziehungsweise zweiter Bilderfassungssensor (11,12) zugeordnet ist.

14. Vorrichtung nach einem der vorhergehenden Ansprüche, **dadurch gekennzeichnet, daß** die erste Optik (13) zwischen dem zweiten Spiegel (9) und dem ersten Bilderfassungssensor (11) und daß die zweite Optik (14) zwischen dem dritten Spiegel (10) und dem zweiten Bilderfassungssensor (12) liegt.

15. Vorrichtung nach einem der vorhergehenden Ansprüche, **dadurch gekennzeichnet, daß** eine erste Beleuchtungsquelle (15) mit dem zweiten Spiegel (9) zusammenwirkt.

16. Vorrichtung nach einem der vorhergehenden Ansprüche, **dadurch gekennzeichnet, daß** eine zweite Beleuchtungsquelle (16) mit dem dritten Spiegel (10) zusammenwirkt.

17. Vorrichtung nach einem der vorhergehenden Ansprüche, **dadurch gekennzeichnet, daß** das Licht einer ringförmigen, etwa ringförmigen oder teilringförmigen dritten Beleuchtungsquelle (19) der optoelektronischen Vorrichtung (1) auf die Leiterplatte (5) gerichtet ist.

18. Vorrichtung nach einem der vorhergehenden Ansprüche, **dadurch gekennzeichnet, daß** die dritte Beleuchtungsquelle (19) den Strahlengang zwischen dem ersten Spiegel (8) und der Leiterplatte (5) umgibt.

19. Vorrichtung nach einem der vorhergehenden Ansprüche, **dadurch gekennzeichnet, daß** die dritte Beleuchtungsquelle (19) von mehreren Licht emittierenden Dioden (LED's) gebildet ist.

## Claims

1. Method for generating test patterns when applying solder paste by a screen printing process on printed circuit boards, a structure being optically detected as reference pattern in a teach-in procedure step and reference data for the test patterns being generated from this detection, **characterised in that** the printing screen for the screen printing process is optically detected as the structure and **in that** the screen openings of the printing screen are detected with respect to their position (coordinates) and/or their geometry (shape, size).

2. Method according to claim 1, **characterised in that** the side of the printing screen which is orientated towards the printed circuit board is optically detected.

3. Method according to one of the preceding claims, **characterised in that**, after the screen printing process, an optical detection of the solder paste application effected on the printed circuit board is implemented and **in that** actual data are generated from this detection.

4. Method according to one of the preceding claims, **characterised in that** the actual data are evaluated taking the reference data into account.

5. Device for generating test patterns when applying solder paste by a screen printing process on printed circuit boards, having a first optoelectronic device for detection of a structure as reference pattern, which detection is effected in a teach-in procedure step, and having a data processing electronic unit for generating reference data from the reference pattern detection, **characterised in that** the first optoelectronic device (6) is disposed such that it detects as the structure the screen openings of the printing screen with respect to their position (coordinates) and/or their geometry (shape and size).

6. Device according to claim 5, **characterised by** a displacement device by means of which the first optoelectronic device (6) can be introduced between the printing screen (3) and the printed circuit board (5) and is moveable there.

7. Device according to one of the preceding claims, **characterised by** a second optoelectronic device (7) for detection of the solder paste application on the printed circuit board (5).

8. Device according to one of the preceding claims, **characterised in that** the first and the second optoelectronic device (6, 7) are moveable by means of one and the same displacement device.

9. Device according to one of the preceding claims, **characterised in that** the first and the second optoelectronic device (6, 7) are formed from only one optoelectronic device (1) which is reversible with respect to the detection direction or has two detection beam paths.

10. Device according to one of the preceding claims, **characterised in that** the optoelectronic device (1) has a first mirror (8) which is metallised on both sides, the one side of which is situated in the beam path which leads to the printing screen (3) and the other side of which is situated in the beam path which leads to the printed circuit board (5).

11. Device according to one of the preceding claims, **characterised in that** a semi-transparent second or third mirror (9, 10) is assigned to each side of the first mirror (8).

12. Device according to one of the preceding claims, **characterised in that** a first or second lens system (13, 14) is assigned respectively to the second and the third mirror (9, 10).

13. Device according to one of the preceding claims, **characterised in that** a first or second image detection sensor (11, 12) is assigned respectively to the second and the third mirror (9, 10).

14. Device according to one of the preceding claims, **characterised in that** the first lens system (13) is situated between the second mirror (9) and the first image detection sensor (11) and **in that** the second lens system (14) is situated between the third mirror (10) and the second image detection sensor (12).

15. Device according to one of the preceding claims, **characterised in that** a first illumination source (15) cooperates with the second mirror (9).

16. Device according to one of the preceding claims, **characterised in that** a second illumination source (16) cooperates with the third mirror (10).

17. Device according to one of the preceding claims, **characterised in that** the light of an annular, approximately annular or partially annular third illumination source (19) of the optoelectronic device (1) is directed onto the printed circuit board (5).

18. Device according to one of the preceding claims, **characterised in that** the third illumination source (19) surrounds the beam path between the first mirror (8) and the printed circuit board (5).

19. Device according to one of the preceding claims, **characterised in that** the third illumination source (19) is formed from a plurality of light emitting diodes (LEDs).

## Revendications

1. Procédé pour générer des motifs de contrôle lors de l'application de pâte à souder, par sérigraphie, sur des plaques de circuit imprimé, selon lequel dans une étape d'apprentissage, on détecte optiquement une structure comme modèle de référence et on génère à partir de cette saisie, les données de référence pour les modèles de contrôle,
**caractérisé en ce qu'**
on détecte optiquement comme structure, le modèle d'impression pour la sérigraphie et on détecte la position (coordonnées) et/ou la géométrie (forme, dimensions) des ouvertures du modèle.

2. Procédé selon la revendication 1,
**caractérisé en ce qu'**
on détecte optiquement le côté du modèle d'impression tourné vers la plaque de circuit imprimé.

3. Procédé selon l'une quelconque des revendications précédentes,
**caractérisé en ce qu'**
après l'opération de sérigraphie, on effectue une saisie optique de l'application de la pâte à souder sur la plaque de circuit imprimé et à partir de cette saisie on génère des données réelles.

4. Procédé selon l'une quelconque des revendications précédentes,
**caractérisé en ce qu'**
on exploite les données réelles en tenant compte des données de référence.

5. Dispositif pour générer des motifs de contrôle pour l'application de pâte à souder par sérigraphie sur des plaques de circuit imprimé, comprenant une première installation optoélectronique pour détecter dans une étape de procédé d'apprentissage une structure comme modèle de référence, et une électronique de traitement de données pour générer des données de référence à partir de la saisie du modèle de référence,
**caractérisé en ce que**
la première installation optoélectronique (6) est conçue pour détecter comme structures, les ouvertures du modèle d'impression par leur position (coordonnées) et/ou leur géométrie (forme, dimensions).

6. Dispositif selon la revendication 5,
**caractérisé par**
une installation de déplacement pour faire passer la première installation optoélectronique (6) entre le modèle d'impression (3) et la plaque de circuit imprimé (5) ou l'en dégager.

7. Dispositif selon l'une quelconque des revendications précédentes,
**caractérisé par**
une seconde installation optoélectronique (7) pour détecter l'application de pâte à souder sur la plaque de circuit imprimé (5).

8. Dispositif selon l'une quelconque des revendications précédentes,
**caractérisé en ce que**
la première et la seconde installation optoélectroniques (6, 7) sont déplacées à l'aide d'une seule et même installation de déplacement.

9. Dispositif selon l'une quelconque des revendications précédentes,
**caractérisé en ce que**
la première et la seconde installation optoélectroniques (6, 7) sont formées par un dispositif optoélectronique (1) dont la direction de détection peut être commutée ou qui comporte deux faisceaux de détection.

10. Dispositif selon l'une quelconque des revendications précédentes,
**caractérisé en ce que**
le dispositif optoélectronique (1) comporte un premier miroir (8) dont les deux faces sont réfléchissantes, une face se trouvant dans le chemin du faisceau dirigé vers le modèle d'impression (3), et l'autre face dans le chemin du faisceau dirigé vers la plaque de circuit imprimé (5).

11. Dispositif selon l'une quelconque des revendications précédentes,
**caractérisé en ce qu'**
un second ou troisième miroir (9, 10) semi transparent sont associés à chaque face du premier miroir (8).

12. Dispositif selon l'une quelconque des revendications précédentes,
**caractérisé en ce qu'**
une première et seconde optique (13, 14) sont associées respectivement au second et au troisième miroir (9, 10).

13. Dispositif selon l'une quelconque des revendications précédentes,
**caractérisé en ce qu'**
un premier et second capteur d'image (11, 12) sont associés respectivement au second et au troisième miroir (9, 10).

14. Dispositif selon l'une quelconque des revendications précédentes,
**caractérisé en ce que**
la première optique (13) est montée entre le second miroir (9) et le premier capteur d'image (11), et la seconde optique (14) entre le troisième miroir (10) et le second capteur d'image (12).

15. Dispositif selon l'une quelconque des revendications précédentes,
**caractérisé en ce qu'**
une première source d'éclairage (15) coopère avec le second miroir (9).

16. Dispositif selon l'une quelconque des revendications précédentes,
**caractérisé en ce qu'**
une seconde source d'éclairage (16) coopère avec le troisième miroir (10).

17. Dispositif selon l'une quelconque des revendications précédentes,
**caractérisé en ce que**
la lumière d'une troisième source d'éclairage (19), annulaire, sensiblement annulaire ou partiellement annulaire, appartenant au dispositif optoélectronique (1) est dirigée vers la plaque de circuit imprimé (5).

18. Dispositif selon l'une quelconque des revendications précédentes,
**caractérisé en ce que**
la troisième source d'éclairage (19) entoure le faisceau entre le premier miroir (8) et la plaque de circuit imprimé (5).

19. Dispositif selon l'une quelconque des revendications précédentes,
**caractérisé en ce que**
la troisième source d'éclairage (19) est constituée par plusieurs diodes photoémissives (LED).
